# EUROPÄISCHE PATENTSCHRIFT

(11) **EP 4 492 477 B1**
(45) Veröffentlichungstag und Bekanntmachung des Hinweises auf die Patenterteilung: **19.08.2026**
(21) Anmeldenummer: 24214890.6
(22) Anmeldetag: 15.10.2020
(51) Int. Cl.: H10F 71/00, H10P 90/00

(54) **VERFAHREN UND TRÄGERELEMENT ZUR HERSTELLUNG EINER WAFERSCHICHT**
METHOD AND CARRIER ELEMENT FOR PRODUCING A WAFER LAYER
PROCÉDÉ ET ÉLÉMENT DE SUPPORT POUR PRODUCTION DE COUCHE DE TRANCHE

(30) Priorität: 14.11.2019 DE 102019130745
(43) Veröffentlichungstag der Anmeldung: 15.01.2025
(62) Dokumentnummer(n) der früheren Anmeldung(en) nach Art. 76 EPÜ: 20793609.7 / 4 059 043
(73) Patentinhaber: Nexwafe GmbH, 79108 Freiburg (DE)
(72) Erfinder: REBER, Stefan, 79194 Gundelfingen (DE); MILENKOVIC, Nena, 79276 Reute (DE); SCHILLINGER, Kai, 79106 Freiburg (DE)
(74) Vertreter: LBP Lemcke, Brommer & Partner Patentanwälte mbB

(56) Entgegenhaltungen:
- WO-A1-2017/136672
- DE-A1- 102015 118 042
- US-A1- 2013 137 244

## Beschreibung

Die Erfindung betrifft ein Verfahren zur Herstellung einer Waferschicht nach dem Oberbegriff des Anspruchs 1 und ein Trägerelement zur Herstellung einer Waferschicht nach Anspruch 12.

Für großflächige elektronische Bauteile wie beispielsweise großflächige Leuchtelemente oder photovoltaische Solarzellen, aber auch für Massenprodukte wie z.B. Halbleiterdioden besteht ein Bedarf an kostengünstigen Halbleiterwafern mit hoher elektronischer Güte, da bei solchen Bauelementen die Materialkosten des Halbleiterwafers einen wesentlichen Anteil an den Kosten des Gesamtprodukts darstellen. Zur Herstellung von Halbleiterwafern sind Verfahren bekannt, wobei aus Siliziumblöcken ("Ingots") mittels Sägeverfahren Halbleiterwafer hergestellt werden. Hierdurch lassen sich hochwertige, insbesondere einkristalline Halbleiterwafer herstellen. Die Herstellungskosten sind jedoch hoch, auch begründet durch den Materialverlust beim Zersägen der Siliziumblöcke.

Es wurden daher alternative Verfahren entwickelt, bei welchen eine Waferschicht auf einem Trägerelement abgeschieden und anschließend von dem Trägerelement abgelöst wird. Die abgelöste Waferschicht stellt somit den Halbleiterwafer zur Herstellung des elektronischen Bauelements dar.

Es ist aus dem Stand der Technik bekannt, auf einer Teilfläche eines Trägersubstrates eine poröse Trennschicht auszubilden und anschließend in einem epitaktischen Prozess eine Waferschicht auf dem Trägersubstrat abzuscheiden. Zur Ablösung der Waferschicht vom Trägersubstrat werden mittels eines Laserstrahles Trennschnitte durchgeführt, welche die Halbleiterschicht vollständig durchdringen und zumindest teilweise in die Trennschicht oder das Trägersubstrat hineinreichen.

Es hat sich jedoch als nachteilig herausgestellt, dass am Randbereich des Trägersubstrates Teile der Waferschicht auf dem Trägersubstrat verbleiben, welche teils schwer zu entfernen sind. Weiterhin werden durch die Trennschnitte auch das Trägersubstrat bzw. die Trennschicht in Mitleidenschaft gezogen, so dass die Trägersubstrate oft nicht zur Herstellung einer weiteren Waferschicht wiederverwendet werden können oder aufwendig aufbereitet werden müssen, wodurch jedoch die Wiederverwendbarkeit limitiert wird.

Eine Optimierung des bekannten Verfahren zur Herstellung einer Halbleiterschicht ist beispielsweise aus der DE 102015118042 A1 bekannt. Hierbei wird auf einem Trägersubstrat vor dem Aufbringen der Waferschicht eine Trennschicht auf zumindest einer Bearbeitungsseite des Trägersubstrates vollflächig ausgebildet und die Waferschicht auf der Bearbeitungsseite und auf zumindest eine Randseite des Trägersubstrates überlappend aufgebracht, wobei vor dem Abtrennen der Waferschicht vom Trägersubstrat die überlappenden Bereiche der Waferschicht entfernt werden.

Die Druckschrift US2013/0137244 A1 offenbart ein Verfahren und eine Anordnung zur Wiederverwendung eines Trägersubstrats.

Durch das überlappende Aufbringen kann die Waferschicht vollständig von der Trennschicht bzw. dem Trägersubstrat abgelöst werden. Für die Wiederverwendbarkeit des Trägersubstrates ist wichtig, dass das Trägersubstrat nach dem Ablösen keine Rückstände der Waferschicht mehr aufweist. Um dies sicherzustellen ist es notwendig, das Trägersubstrat beim Abtrennen der überlappenden Bereiche auch zu besäumen und wenige Mikrometer abzutragen, so dass sich die lateralen Abmessungen des Trägersubstrates nach jeder Verwendung reduzieren. Sobald eine Mindest-Abmessung des Trägersubstrates unterschritten ist, kann dieses nicht mehr als Trägersubstrat für die Herstellung weiterer Waferschichten verwendet werden.

Für einen industriellen Einsatz ist eine Kostenreduktion bei der Herstellung der Waferschichten, insbesondere durch die Wiederverwendbarkeit von Trägersubstraten, notwendig.

Der vorliegenden Erfindung liegt daher die Aufgabe zugrunde, die Wiederverwendbarkeit von Trägersubstraten zu erhöhen und eine Kostenreduktion in der Herstellung einer Waferschicht zu erzielen.

Der vorliegenden Erfindung liegt weiter die Aufgabe zugrunde, die Qualität in der Herstellung einer Waferschicht weiter zu verbessern, insbesondere durch das Trägersubstrat oder die Trennschicht induzierte Fehler zu reduzieren.

Gelöst werden diese und weitere Aufgaben durch ein Verfahren zur Herstellung einer Waferschicht gemäß Anspruch 1, durch ein Trägerelement zur Herstellung einer Waferschicht gemäß Anspruch 12, sowie durch ein Zwischenerzeugnis gemäß Anspruch 15. Vorteilhafte Ausgestaltungen des Verfahrens finden sich in den Ansprüchen 2 bis 11; vorteilhafte Ausgestaltungen des Trägerelementes zur Herstellung einer Waferschicht finden sich in den Ansprüchen 13 bis 14.

Das erfindungsgemäße Verfahren zur Herstellung einer Halbleiterschicht weist folgende Verfahrensschritte auf:
Ein erster Verfahrensschritt A umfasst das Bereitstellen eines Trägerelementes. In einem Verfahrensschritt B erfolgt das Porosifizieren des Trägerelementes an zumindest einer Oberfläche des Trägerelementes zur Erzeugung einer Trennschicht. Insbesondere kann durch das Porosifizieren die Trennschicht auch zumindest teilweise entlang einer oder mehrerer Seitenflächen des Trägerelementes ausgebildet werden. In einem Verfahrensschritt C erfolgt das Aufbringen einer Waferschicht auf die Trennschicht des Trägerelementes mittels Epitaxie. In einem weiteren Verfahrensschritt D erfolgt das Ablösen der Waferschicht von dem Trägerelement. Weiter zeichnet das Verfahren aus, dass die Verfahrensschritte B bis D zumindest einmal, bevorzugt mehrfach mit dem Trägerelement wiederholt werden.

Diese Verfahrensschritte sind an sich aus dem Stand der Technik bekannt. Die abgelöste Waferschicht findet insbesondere Verwendung bei der Herstellung eines elektronischen Bauelements und wird insbesondere zur Herstellung einer photovoltaischen Solarzelle verwendet.

Das erfindungsgemäße Verfahren zeichnet sich dadurch aus, dass der Verfahrensschritt A die weiteren Verfahrensschritte A1 und A2 umfasst, wobei in Verfahrensschritt A1 ein Trägersubstrat bereitgestellt wird und in Verfahrensschritt A2 ein Aufbringen einer Saatschicht auf zumindest eine Oberfläche und zumindest eine Seitenfläche des Trägersubstrates mittels Epitaxie zur Herstellung des Trägerelementes erfolgt, wobei die Saatschicht mit einer größeren Schichtbreite als Schichtstärke aufgebracht wird.

Es hat sich insbesondere gezeigt, dass mit dem erfindungsgemäßen Verfahren das Trägerelement mehrmals für die Herstellung von Waferschichten verwendet werden kann ohne dabei Einbußen in Bezug auf die Qualität der Waferschicht einzugehen.

Insbesondere ermöglicht das erfindungsgemäße Verfahren eine gegenüber dem Stand der Technik häufigere Verwendung des Trägersubstrates, da die epitaktische Saatschicht und die Trennschicht auf dem Trägersubstrat wiederherstellbar sind. Sofern eine Mindest-Abmessung des Trägerelementes erreicht wird, wobei die Mindest-Abmessung des Trägerelementes zumindest den Abmessungen des Trägersubstrates entsprechen, kann die Saatschicht erneut mittels Epitaxie auf dem Trägersubstrat aufgebracht werden und das Trägerelement wiederaufbereitet werden. Dies wird insbesondere dadurch ermöglicht, dass das Trägersubstrat während des gesamten Verfahrens in seiner Qualität und seinen Eigenschaften, insbesondere seinen Abmessungen, nicht oder nur in einem geringen Umfang verändert wird.

Weiter ermöglicht das erfindungsgemäße Verfahren das Trägerelement, insbesondere die epitaktische Saatschicht, auf die notwendigen Eigenschaften für die weiteren Verfahrensschritte wie die Porosifizierung anzupassen. Somit sind keine speziellen, oft teuren, Trägersubstrate notwendig, welche durch Ihre speziellen Eigenschaften oft eine geringere Qualität aufweisen.

Insbesondere weist die epitaktische Saatschicht eine höhere Qualität und Homogenität, insbesondere in Bezug auf die Kristallstruktur und den elektronischen Eigenschaften, gegenüber einem in einem Zonenschmelz- oder Kristallzüchtungsverfahren hergestellten Trägersubstrat auf.

Durch die häufige Verwendung eines Trägersubstrates in der Herstellung für eine Vielzahl von Waferschichten können insbesondere sehr hochwertige Trägersubstrate, insbesondere in Bezug auf die Kristallqualität und die Oberfläche, verwendet werden. Fehler in der Kristallstruktur und/oder der Oberfläche des Trägersubstrates wirken sich unmittelbar auf die Qualität der epitaktischen Saatschicht und der Waferschicht aus. Insbesondere können weitere Fehler in der Kristallstruktur der Saatschicht und Waferschicht durch Fehler in der Kristallstruktur und/oder der Oberfläche des Trägersubstrates induziert werden.

Hochwertige Trägersubstrate erlauben somit eine höhere Qualität im Aufbringen weiterer Schichten mittels Epitaxie und ermöglichen eine höhere Prozessausbeute. Insbesondere amortisieren sich die höheren Kosten für hochwertige Trägersubstrate durch die häufige Verwendung und Wiederaufbereitung der darauf basierenden Trägerelemente für die Herstellung von Waferschichten, so dass eine Kostenreduktion in der Herstellung der Waferschichten insgesamt erzielt werden kann.

In vorteilhafter Weise werden die Verfahrensschritte B bis D mit einem Trägerelement zumindest 10 Mal, bevorzugt zumindest 20 Mal, besonders bevorzugt zumindest 30 Mal durchgeführt.

Insbesondere kann ein Trägerelement umfassend ein Trägersubstrat und eine epitaktische Saatschicht solange zur Herstellung von Waferschichten verwendet werden, bis eine vorgegebene Mindest-Abmessung des Trägerelementes erreicht oder geringfügig, insbesondere bevorzugt um weniger als 10 µm, besonders bevorzugt um weniger als 5 µm, höchst bevorzugt um weniger als 3 µm, unterschritten wird.

Die Mindest-Abmessung bezieht auf die Abmessung des Trägerelementes in lateraler Richtung und insbesondere bevorzugt auch in vertikaler Richtung.

Insbesondere kann die Abmessung des Trägersubstrates in lateraler und insbesondere bevorzugt in vertikaler Richtung eine Mindest-Abmessung für das Trägerelement darstellen.

In vorteilhafter Weise kann das Trägerelement bei Erreichen oder Unterschreiten der Mindest-Abmessung wiederaufbereitet werden und danach weiter als Trägerelement für die Herstellung von Waferschichten eingesetzt werden.

Bevorzugt erfolgt die Wiederaufbereitung des Trägerelementes durch Durchführung des Verfahrensschrittes A2 mit dem zuvor verwendeten Trägersubstrat.

Vor der erneuten Durchführung des Verfahrensschritts A2 auf einem bereits benutzten Trägerelement kann dieses Trägerelement respektive das Trägersubstrat einer ersten Aufbereitung unterzogen werden, so dass wiederum die Ausbildung einer qualitativ hochwertigen Saatschicht auf dem bereits in Benutzung gewesenen Trägerelement ermöglicht werden kann.

Insbesondere kann das zur Wiederverwendung bereitgestellte Trägerelement bzw. das Trägersubstrat durch mechanische Behandlung wie Polieren oder Schleifen oder chemische Behandlung wie Ätzen oder einer Kombination von chemischer und mechanischer Behandlung vor dem Verfahrensschritt A2 aufbereitet werden, so dass dieses insbesondere eine hochwertige Oberfläche, auf welcher anschließend die Saatschicht aufgebracht wird, aufweist.

Durch die Wiederaufbereitung des Trägerelementes wird eine vielfach häufigere Verwendung eines ursprünglichen Trägersubstrates in der Herstellung von Waferschichten erzielt. Insbesondere können durch die vielfach häufigere Verwendung qualitativ hochwertige Trägersubstrate genutzt werden, wodurch gleichzeitig auch die Qualität der Waferschichten erhöht wird. Auch wenn höhere Kosten mit einem qualitativ hochwertigeren Trägersubstrat verbunden sind, so sind die Kosten für die Herstellung der einzelnen Waferschicht durch die vielfach häufigere Verwendung des Trägersubstrates, insbesondere durch die Wiederaufbereitung des das Trägersubstrat umfassenden Trägerelementes, geringer.

Die Epitaxie der Saatschicht und der Waferschicht werden vorzugsweise in der gleichen Epitaxie-Vorrichtung durchgeführt. Alternativ können die Saatschicht und die Waferschicht auch in verschiedenen Epitaxie-Vorrichtungen durchgeführt werden.

Bevorzugt wird ein Trägersubstrat in einem Trägerelement zur Herstellung von zumindest 50, bevorzugt von zumindest 100, besonders bevorzugt zumindest 150 Waferschichten verwendet.

Insbesondere kann das Trägersubstrat eine glatt geschliffene oder polierte Oberfläche aufweisen. Die Qualität der epitaktischen Saatschicht und der Waferschicht können somit noch weiter verbessert werden.

Insgesamt kann mit dem erfindungsgemäßen Verfahren die Qualität der Waferschichten, insbesondere in Bezug auf die Kristallstruktur und die elektronischen Eigenschaften, verbessert werden und gleichzeitig die Kosten in der Herstellung durch die Wiederverwendbarkeit und Wiederherstellbarkeit des Trägerelementes gesenkt werden.

Die epitaktische Saatschicht und die epitaktische Waferschicht werden mittels chemischer oder physikalischer Gasphasenabscheidung oder Mischformen hiervon aufgebracht. Insbesondere erfolgt das Aufbringen der Saatschicht und Waferschicht bevorzugt mittels chemischer Gasphasenepitaxie. Epitaxie ermöglicht die Herstellung qualitativ hochwertiger Schichten, insbesondere in Bezug auf die Kristallstruktur und das geringe Einbringen von Fremdstoffen.

Die Trennschicht ist bevorzugt in an sich bekannter Weise als poröse Schicht ausgebildet. Insbesondere wird zum Erzeugen der Trennschicht vorteilhafterweise das Trägersubstrat in an sich bekannter Weise porosifiziert, insbesondere mittels eines Ätzvorgangs, wie beispielsweise in DE 102013219839 A1 beschrieben.

In einer bevorzugten Ausgestaltung des Verfahrens wird die Saatschicht die eine Oberfläche und alle Seitenflächen des Trägersubstrates ummantelnd aufgebracht.

Somit kann eine einheitliche, insbesondere homogene Fläche aus einem Material als eine Nukleationsschicht für die Herstellung der Waferschicht bereitgestellt werden und Defekte verursachende Stellen außerhalb der Saatschicht, insbesondere am Trägersubstrat, vermieden werden.

Des Weiteren können durch eine Ummantelung des Trägersubstrates an zumindest einer Oberfläche und allen Seitenflächen Inhomogenitäten während der Porosifizierung in Verfahrensschritt B vermieden werden.

Insbesondere kann die Saatschicht auf alle Oberflächen und alle Seitenflächen des Trägersubstrats aufgebracht werden und das Trägersubstrat vollständig ummanteln. Das Trägersubstrat ist somit vollständig von der Saatschicht umgeben.

Es hat sich auch der Vorteil gezeigt, dass durch eine Ummantelung des Trägersubstrates an zumindest einer Oberfläche und allen Seitenfläche das Trägersubstrat vor Beschädigungen geschützt werden kann und die Wiederverwendbarkeit somit weiter erhöht werden kann.

Eine vorteilhafte Ausgestaltung des Verfahrens zeichnet aus, dass das Trägersubstrat und die Saatschicht aus Silizium, Germanium oder Galliumarsenid ausgebildet sind oder werden.

Silizium ist in einer hohen Qualität in großen Mengen und auch für großflächige Anwendungen verfügbar, so dass sich die Verwendung von Silizium insbesondere für das Trägersubstrat eignet. Vorzugsweise wird die Saatschicht auf einem Trägermaterial aus Silizium auch aus Silizium gebildet, um ein Trägerelement aus einem Material zu bilden.

Bevorzugt ist das Trägersubstrat nur schwach dotiert.

Schwach dotierte Trägersubstrate können mit einer hohen Qualität hergestellt werden, da durch eine schwache Dotierung neben dem eigentlichen Dotierelement nur eine geringe Menge an Fremdstoffen eingebracht werden, welche insbesondere zu Fehlern in der Gitterstruktur des Trägersubstrates führen, und weitere Fehler im Aufbau der epitaktischen Saatschicht induzieren können.

Gemäß einer alternativen Ausführungsform des Verfahrens ist das Trägersubstrat n-dotiert oder p-dotiert, wobei die Dotierkonzentration im Bereich kleiner 5 x 10¹⁹ cm⁻³, bevorzugt im Bereich kleiner 1 x 10¹⁸ cm⁻³, besonders bevorzugt im Bereich kleiner 1 x 10¹⁷ cm⁻³, höchst bevorzugt im Bereich 5 x 10¹⁵ cm⁻³ liegt.

Eine geringe Dotierkonzentration des Trägersubstrates im vorgenannten Bereich erlaubt eine positive Beeinflussung der Eigenschaften der Saatschicht, insbesondere wenn die Saatschicht mit dem gleichen Dotierelement, aber meist mit einer höheren Dotierkonzentration, dotiert wird.

Bevorzugt hat das Trägersubstrat durch die geringere Dotierkonzentration auch eine geringere Konzentration an sonstigen Verunreinigungen, so dass auch die Saatschicht und die Waferschicht eine geringere Verunreinigungskonzentration und damit eine höhere Schichtqualität aufweisen.

In vorteilhafter Weise werden zur Dotierung eines Trägersubstrates aus Silizium oder Germanium die Dotierelemente Bor, Phosphor, Gallium oder Arsen verwendet.

Die Leitfähigkeit des Trägersubstrates liegt insbesondere unter einem Wert von 10 Ohmcm. Bevorzugt liegt die Leitfähigkeit des Trägersubstrates vorzugsweise in einem Bereich zwischen 2 mOhmcm und 3000 mOhmcm, bevorzugt in einem Bereich von 10 mOhmcm bis 200 mOhmcm, insbesondere um 100 mOhmcm.

Eine bevorzugte Ausführungsform des Verfahrens zeichnet aus, dass die Saatschicht auf der zumindest einen Oberfläche des Trägersubstrates mit einer Schichtstärke im Bereich von 10 µm bis 250 µm, bevorzugt im Bereich von 25 µm bis 100 µm, besonders bevorzugt im Bereich von 40 µm bis 80 µm aufgebracht wird.

Alternativ oder ergänzend wird die Saatschicht auf der zumindest einen Seitenfläche des Trägersubstrat mit einer Schichtbreite im Bereich von 10 µm bis 600 µm, bevorzugt im Bereich von 25 µm bis 400 µm, besonders bevorzugt im Bereich von 50 µm bis 250 µm aufgebracht.

Beim Ablösen der Waferschicht vom Trägerelement, insbesondere durch das Besäumen der abzulösenden Waferschicht und der Porosifizierung des Trägerelementes kann es zu einer Verringerung der Schichtstärke und der Schichtbreite kommen. Eine entsprechende Schichtstärke oder Schichtdicke erlaubt die Durchführung einer Vielzahl von Zyklen der Verfahrensschritte B bis D zur Herstellung einer Waferschicht mit dem gleichen Trägerelement bis zum Erreichen der Mindest-Abmessungen des Trägerelementes.

Für eine Wiederverwendung des Trägerelementes ist es notwendig, dass vor dem Ausbilden einer weiteren Waferschicht die zuvor aufgebrachten Waferschicht vollständig abgelöst wurde. Zur Sicherstellung der vollständigen Ablösung der Waferschicht vom dem Trägerelement, ist es daher meist erforderlich bei jedem Ablösen der Waferschicht auch das Trägerelement geringfügig, insbesondere in einem Bereich von 2 µm bis 20 µm, zu besäumen.

Bei jedem Ablösen einer Waferschicht vom Trägerelement wird das Trägerelement in seinen Abmessungen geringfügig, insbesondere in einem Bereich von 2 µm bis 20 µm, verkleinert. Es hat sich jedoch gezeigt, dass die Schichtbreite beim Ablösen der Waferschicht meist stärker verringert wird als die Schichtstärke. Eine größere Schichtbreite ermöglicht daher eine größere Anzahl an den Zyklen der verfahrensschritte B bis D bis die Mindest-Abmessungen sowohl in der Schichtbreite als in der Schichtstärke erreicht werden.

Eine größere Schichtbreite als Schichtstärke ermöglicht es weiter, das Besäumen der Kanten der Waferschicht, um auch vor dem Ablösen der Waferschicht entsprechend über das Trägerelement hinausgehendes Material abzutrennen, mit einer größeren Toleranz und entsprechend kostengünstigeren Einrichtungen durchzuführen.

Gemäß einer alternativen Ausführungsform des Verfahrens wird die Saatschicht während des Aufbringens n-dotiert oder p-dotiert mit einer Dotierkonzentration im Bereich von 1 x 10¹⁶ cm⁻³ bis 5 x 10¹⁹ cm⁻³, bevorzugt im Bereich von 1 x 10¹⁷ cm⁻³ bis 3 x 10¹⁹ cm⁻³, insbesondere im Bereich von 1 x 10¹⁸ cm⁻³ bis 1 x 10¹⁹ cm⁻³.

Durch eine Dotierung der Saatschicht während der Epitaxie kann die Qualität der Saatschicht auf Grund der hohen Reinheit der Dotierelemente verbessert hergestellt werden. Insbesondere im Vergleich zu einem Trägerelement, welches aus einem mittels Zonenschmelz- oder Kristallzüchtungsverfahren, wie dem Czochralski-Verfahren, hergestellten Block geschnitten wurde, kann der Eintrag an Fremdstoffen, insbesondere von Metallen, um einen Faktor größer 10, insbesondere größer 50 verringert werden. Ein verringerter Eintrag an Fremdstoffen führt zu einer erhöhten Qualität der Saatschicht und entsprechend auch der Waferschicht.

Weiterhin können Fremdstoffe auch die Ausbildung der Trennschicht und den Prozess des Porosifizierens beeinflussen, so dass ein geringer Eintrag an Fremdstoffen sich hier auch positiv, insbesondere auch auf die Gleichmäßigkeit der Ausbildung der Trennschicht auf die Oberfläche, auswirkt.

Weiterhin ermöglicht eine Dotierung der Saatschicht eine gute elektrische Kontaktierung der Saatschicht des Trägerelementes während der Porosifizierung, welches sich vorteilhaft auf den Ätzvorgang auswirkt.

In vorteilhafter Weise werden zur Dotierung einer Saatschicht aus Silizium oder Germanium die Dotierelemente Bor, Phosphor, Gallium oder Arsen verwendet.

Die Leitfähigkeit der Saatschicht liegt vorzugsweise in einem Bereich zwischen 2 mOhmcm bis 500 mOhmcm, bevorzugt in einem Bereich von 5 mOhmcm bis 25 mOhmcm, insbesondere um 15 mOhmcm.

Bevorzugt wird auf der der Saatschicht abgewandten Oberfläche des Trägersubstrates eine Kontaktschicht vor, während oder nach dem Aufbringen der Saatschicht aufgebracht, ausgebildet oder angeordnet.

Die Kontaktschicht erlaubt eine gute, insbesondere trockene Kontaktierung des Trägerelementes, welche insbesondere für den Prozess des Porosifizierens von Bedeutung ist. Die Eigenschaften der Kontaktschicht können dabei unabhängig von den Eigenschaften des Trägerelementes, des Trägersubstrates und/oder der Saatschicht auf die jeweiligen Gegebenheiten entsprechend angepasst werden. Bevorzugt hat die Kontaktschicht metallische oder metall-ähnliche elektrische Eigenschaften.

Eine vorteilhafte Ausgestaltung des Verfahrens zeichnet aus, dass die Kontaktschicht durch Diffusion von einer Diffusionsschicht auf der der Saatschicht abgewandten Oberfläche des Trägersubstrates in das Trägersubstrat ausgebildet wird, wobei die Diffusionsschicht insbesondere durch ein Halteelement zum Halten des Trägersubstrates während des Verfahrensschrittes A2 ausgebildet wird oder vor dem Verfahrensschritt A2 auf der der Saatschicht abgewandten Oberfläche des Trägersubstrates aufgebracht wird.

Durch die Festkörperdiffusion wird eine kostengünstige Ausbildung einer Kontaktschicht bereits während der Herstellung der Saatschicht ermöglicht. Somit sind keine weiteren Verfahrensschritte, wie ein separates anordnen oder aufbringen der Kontaktschicht notwendig.

Eine weitere vorteilhafte Ausgestaltung des Verfahrens zeichnet aus, dass die Kontaktschicht aus polykristallinem Halbleitermaterial, insbesondere aus poly-Silizium, gebildet ist oder wird.

Ein polykristallines Material bietet den Vorteil einer kostengünstigen und guten trockenen Kontaktierung des Trägerelementes.

Bevorzugt können durch eine polykristalline oder eine hochdotierte, insbesondere mit dem Dotierelement Phosphor dotierte Kontaktschicht Verunreinigungen, insbesondere aus dem Trägersubstrat, gegettert oder immobilisiert werden. Die Qualität der Saatschicht kann somit weiter verbessert werden.

Alternativ oder ergänzend wird die Kontaktschicht über das Trägersubstrat überstehend ausgebildet oder angeordnet.

Bevorzugt weist die Kontaktschicht eine Dicke im Bereich von 0,1 bis 20 µm, insbesondere im Bereich von 1 bis 12 µm auf. Die Dicke der Kontaktschicht richtet sich insbesondere nach deren Aufgabe und Eigenschaften, insbesondere ermöglicht die bevorzugte Dicke der Kontaktschicht eine gute Kontaktierung des Trägerelementes und ausreichende Stabilität.

Eine alternative Ausgestaltung des Verfahrens zeichnet aus, dass die Saatschicht mit einer inhomogenen Schichtstärke auf das Trägersubstrat aufgebracht wird, wobei insbesondere bevorzugt die Schichtstärke zumindest zu einer, bevorzugt zu zwei gegenüberliegenden Seitenflächen des Trägersubstrates hin zunimmt oder abnimmt.

Weiter bevorzugt kann die Änderung der Schichtstärke zu den Seitenflächen von der Mitte der Saatschicht insbesondere stetig erfolgen.

Durch die Ausbildung einer inhomogenen Schichtstärke können Inhomogenitäten während des Prozesses der Porosifizierung, insbesondere Inhomogenitäten in Bezug auf den angelegten Strom und das elektrische Feld, entgegengewirkt werden.

Die vorliegende Erfindung betrifft weiterhin ein Trägerelement für die Herstellung einer Waferschicht gemäß Anspruch 12.

Das Trägerelement umfasst ein Trägersubstrat, welches insbesondere aus Silizium, Germanium oder Galliumarsenid gebildet ist und eine epitaktische Saatschicht, welche auf zumindest eine Oberfläche und zumindest eine Seitenfläche des Trägersubstrats aufgebracht ist, sowie eine Trennschicht, gebildet durch die Porosifizierung der zumindest einen Oberfläche der epitaktischen Saatschicht, wobei die Saatschicht eine größere Schichtbreite als Schichtstärke aufweist.

Bevorzugt ummantelt die Saatschicht die eine Oberfläche und alle Seitenflächen des Trägersubstrates.

Insbesondere kann die Saatschicht auf alle Oberflächen und alle Seitenflächen des Trägersubstrats aufgebracht sein und das Trägersubstrat vollständig ummanteln.

Das Trägersubstrat kann somit vor äußeren Einflüssen, welche die Wiederverwendbarkeit des Trägersubstrates beeinflussen, geschützt werden.

Eine vorteilhafte Ausgestaltung des Trägerelementes zeichnet aus, dass die Saatschicht auf der zumindest einen Oberfläche des Trägersubstrates eine Schichtstärke im Bereich von 10 µm bis 250 µm, bevorzugt im Bereich von 25 µm bis 100 µm, besonders bevorzugt im Bereich von 40 µm bis 80 µm aufweist.

Alternativ oder ergänzend weist die Saatschicht auf der zumindest einen Seitenfläche des Trägersubstrats eine Schichtbreite im Bereich von 10 µm bis 600 µm, bevorzugt im Bereich von 25 µm bis 400 µm, besonders bevorzugt im Bereich von 50 µm bis 250 µm auf.

Beim Ablösen der Waferschicht vom Trägerelement, insbesondere durch das Besäumen der abzulösenden Waferschicht und der Porosifizierung des Trägerelementes kann es zu einer Verringerung der Schichtstärke und der Schichtbreite kommen. Eine entsprechende Schichtstärke oder Schichtdicke des Trägerelementes ermöglicht die Durchführung einer Vielzahl von Zyklen der Verfahrensschritte B bis D zur Herstellung einer Waferschicht mit dem gleichen Trägerelement bis zum Erreichen der Mindest-Abmessungen des Trägerelementes. In vorteilhafter Weise ist auf der der Saatschicht abgewandten Oberfläche des Trägersubstrates eine Kontaktschicht, bevorzugt aus polykristallinem Halbleitermaterial, insbesondere poly-Silizium, angeordnet.

Die Ausbildung der Kontaktschicht kann insbesondere durch Festkörperdiffusion von einem das Trägerelement während der Herstellung der Saatschicht haltendem Halteelement oder von einer auf der der Saatschicht abgewandten Oberfläche des Trägersubstrates aufgebrachten Dotierstoff-haltigen Schicht in das Trägersubstrat erfolgen. Dies erlaubt eine kostengünstige Herstellung der Kontaktschicht ohne einen separaten Verfahrensschritt zum Aufbringen oder Anordnen der Kontaktschicht an dem Trägerelement.

Die Kontaktschicht erlaubt eine gute Kontaktierung des Trägerelementes, insbesondere während der Porosifizierung.

Das erfindungsgemäße Trägerelement findet bevorzugt Verwendung bei der Herstellung einer Halbleiterschicht gemäß dem erfindungsgemäßen Verfahren, insbesondere einer vorteilhaften Ausführungsform hiervon.

Die vorliegende Erfindung betrifft weiter ein Zwischenerzeugnis im Zuge der Herstellung einer Waferschicht gemäß Anspruch 15.

Das Zwischenerzeugnis umfasst ein erfindungsgemäßes Trägerelement wie vorstehend ausgeführt, insbesondere einer vorteilhaften Ausführungsform des Trägerelementes, und eine, auf der Trennschicht angeordnete epitaktische Waferschicht.

Das Zwischenerzeugnis findet bevorzugt Verwendung bei der Herstellung einer Halbleiterschicht gemäß dem erfindungsgemäßen Verfahren, insbesondere einer vorteilhaften Ausführungsform hiervon.

Weitere vorteilhafte Merkmale und Ausgestaltungen werden im Folgenden anhand von Ausführungsbeispielen und den Figuren erläutert. Dabei zeigen:
- Figuren 1a bis 1d: ein Ausführungsbeispiel eines erfindungsgemäßen Verfahrens zum Herstellen einer Waferschicht;
- Figur 2: ein Ausführungsbeispiel eines erfindungsgemäßen Trägerelementes;
- Figuren 3a und 3b: weitere Ausführungsbeispiele eines erfindungsgemäßen Trägerelementes;

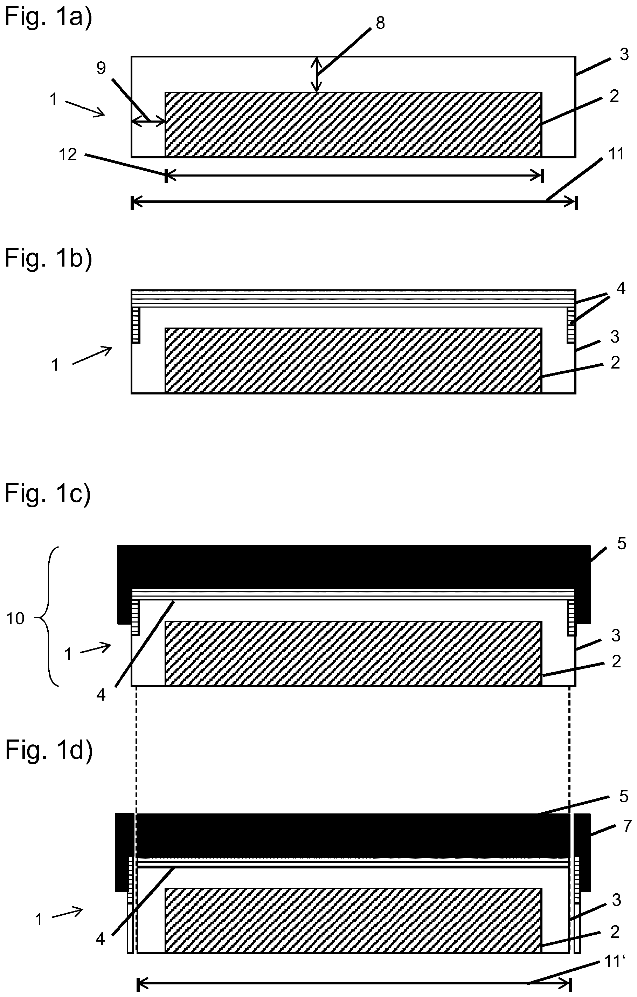

Sämtliche Figuren sind schematische, nicht maßstabsgerechte Darstellungen. In den Figuren bezeichnen gleiche Bezugszeichen gleiche oder gleichwirkende Elemente. In den Figuren 1 bis 3 befindet sich eine Oberfläche eines Trägersubstrates 2 oder eines Trägerelementes 1, auf welche eine Saatschicht 3 aufgebracht wird, stets obenliegend.

In den Figuren 1a) bis 1d) ist ein erfindungsgemäßes Verfahren zum Herstellen einer Waferschicht dargestellt.

Wie in Figur 1a) dargestellt, wurde an einem in einem Verfahrensschritt A1 bereitgestellten Trägersubstrat 2 in einem Verfahrensschritt A2 eine Saatschicht 3 mittels Epitaxie zur Ausbildung eines Trägerelementes 1 abgeschieden, welches zur Herstellung einer Waferschicht 5 verwendet wird. Die Saatschicht 3 ummantelt das Trägersubstrat 2 an einer oberen Oberfläche und den Seitenflächen vollständig. Die der oberen Oberfläche abgewandte untere Seite des Trägersubstrates 2 ist nicht von der Saatschicht 3 bedeckt.

Bei dem Trägersubstrat 2 handelt es sich um einen Halbleiter, insbesondere aus Silizium, welcher in einem Zonenschmelz- oder Kristallzüchtungsverfahren hergestellt wurde. Die Dicke des Trägersubstrates 2 liegt im Bereich von 250 µm bis 1000 µm. Das Trägersubstrat 2 weist eine quadratische Grundform auf, deren Seitenkanten eine Länge von 100 mm bis 300 mm, insbesondere von 140 bis 170 mm aufweist. Neben einer quadratischen Grundform kann das Trägersubstrat 2 auch eine pseudo-quadratische Form mit abgeschrägten / abgerundeten Ecken, oder eine runde, ovale oder rechteckige Form aufweisen.

Das Trägersubstrat 2 weist in lateraler Richtung eine Abmessung 12 auf, an welche sich an den Seitenflächen des Trägersubstrates 2 die Schichtbreite 9 der Saatschicht 3 anschließt, so dass das Trägerelement 1 insgesamt eine laterale Abmessung 11 aufweist.

Auf der Oberfläche des Trägersubstrates 2 ist die Saatschicht 3 mit einer Schichtstärke 8 aufgebracht. Die Schichtstärke 8 ist, wie in Figur 1a) dargestellt, im Wesentlichen zu der Schichtbreite 9 identisch.

Die Saatschicht 3 wurde mittels Epitaxie, insbesondere mittels chemischer Gasphasenabscheidung, auf dem Trägersubstrat 2 aufgebracht. Durch Epitaxie lassen sich qualitativ hochwertige Schichten ausbilden, welches ein entscheidender Ausgangspunkt für die Herstellung von entsprechend qualitativ hochwertigen Saatschichten 3 ist. Insbesondere kann durch Epitaxie die Saatschicht 3 an die notwendigen Erfordernisse, insbesondere hinsichtlich der Kristallqualität und der elektrischen Eigenschaften, für einen nachfolgenden Prozess angepasst werden.

In einem der Herstellung des Trägerelementes 1 nachfolgenden Prozessschritt B wird auf der Oberfläche sowie zumindest teilweise an den Seitenrändern des Trägerelementes 1 und somit auf der Oberfläche und zumindest teilweise an den Seitenrändern der Saatschicht 3 eine poröse Trennschicht 4 ausgebildet, wie in Figur 1b) dargestellt. Die Trennschicht 4 weist eine Dicke bzw. Stärke von bis zu 3 µm, vorliegend etwa 2 µm auf. Die Ausbildung der Trennschicht 4 auf dem Trägerelement 1 erfolgt mittels Ätzen, insbesondere Porosifizierung, und kann beispielsweise wie in DE 10 2013 219 886 A1 beschrieben durchgeführt werden. Das beschriebene Verfahren ermöglicht eine vollflächige Ausbildung der Trennschicht 4 auf der Oberfläche des Trägerelementes 1.

In einen weiteren Verfahrensschritt C wird auf der Trennschicht 4 des Trägerelementes 1 eine epitaktische Waferschicht 5 abgeschieden. Die Waferschicht 5 überlappt die Seitenflächen des Trägerelementes 1 teilweise und kann sich weiter auch über einen Teil der Seitenflächen des Trägerelementes 1 erstrecken. Durch die verbreiterte Ausbildung der Waferschicht 5 wird eine hohe Qualität der Waferschicht 5 bis nahezu an dessen Randbereich sichergestellt. Dies ist in Figur 1c) dargestellt.

Das das Trägerelement 1 und die Waferschicht 5 umfassende Erzeugnis wird auch als Zwischenerzeugnis 10 bezeichnet.

In einem weiteren Verfahrensschritt wird das so hergestellte Zwischenerzeugnis 10 aus Trägerelement 1 und Waferschicht 5 an den Seitenflächen des Trägerelementes 1 besäumt. Durch die Besäumung werden über das Trägerelement 1 überstehende Teile 7 der Waferschicht 5 wie auch möglicherweise an den Seitenflächen des Trägerelementes 1 anhaftende weitere Teile der Waferschicht 5 entfernt, wie in Figur 1d) dargestellt.

Das Besäumen erfolgt durch einen Laserstrahl. Alternativ kann das Besäumen auch durch mechanische Bearbeitung wie Sägen oder Schleifen erfolgen. Insbesondere wird durch das Besäumen erzielt, dass am Trägerelement 1 anhaftende Teile der Waferschicht 5 entfernt werden, so dass eine Wiederverwendung des Trägerelementes 1 ermöglicht wird. Allerdings ist es dazu meist erforderlich auch das Trägerelement 1 an seinen Seitenflächen minimal abzutragen, so dass sich eine laterale Abmessung 11' ergibt, welche geringer ist als die ursprüngliche laterale Abmessung 11 nach Verfahrensschritt A.

Nach dem Besäumen des Zwischenerzeugnisses 10 erfolgt in einem Verfahrensschritt D das Ablösen der Waferschicht 5 von dem Trägerelement 1.

Das Trägerelement 1 durchläuft nach dem Ablösen der Waferschicht 5 wiederum die Verfahrensschritte B bis D, wie in den Figuren 1b bis 1d) dargestellt, zur Erzeugung einer weiteren Waferschicht 5.

Eine geringere laterale Abmessung 11' des Trägerelementes 1 beeinflusst die Herstellung der Waferschicht 5 nicht negativ, solange das Trägerelement 1 frei von Rückständen einer zuvor aufgetragenen Waferschicht 5 ist und die geringere laterale Abmessung 11' des Trägerelementes 1 und insbesondere bevorzugt auch die Stärke des Trägerelementes 11 eine Mindest-Abmessung nicht unterschreitet. Daher wird ein Zyklus der Verfahrensschritte B bis D bis zum Erreichen oder einem geringfügigen Unterschreiten der Mindest-Abmessungen des Trägerelementes 1 beliebig oft wiederholt.

Eine untere Grenze für die Mindest-Abmessung stellt die laterale Abmessung 12 und auch die Dicke des Trägersubstrates 2 dar. Sobald sich die laterale Abmessung 11' der lateralen Abmessung 12 respektive die entsprechende Stärke des Trägerelementes 1 der Dicke des Trägersubstrates 2 nähert, wird das Trägerelement 1 durch das Durchführen des Verfahrensschritts A2 und dem daraus resultierenden erneuten Aufbringen einer Saatschicht 3 auf das Trägerelement 1 oder das Trägersubstrat 2 aufbereitet.

Vor der erneuten Durchführung des Verfahrensschritts A2 auf einem bereits benutzten Trägerelement 1 kann dieses Trägerelement 1 respektive das Trägersubstrat 2 einer ersten Aufbereitung unterzogen werden, so dass wiederum die Ausbildung einer qualitativ hochwertigen Saatschicht 3 auf dem bereits in Benutzung gewesenen Trägerelement 1 ermöglicht werden kann. Dazu kann das zur Wiederverwendung bereitgestellte Trägerelement 1 bzw. das Trägersubstrat 2 durch mechanische Behandlung wie Polieren oder Schleifen oder chemische Behandlung wie Ätzen oder einer Kombination von chemischer und mechanischer Behandlung vor dem Verfahrensschritt A2 aufbereitet werden, so dass dieses insbesondere eine hochwertige Oberfläche, auf welcher anschließend die Saatschicht 3 aufgebracht wird, aufweist.

Sofern die Abmessung 11' des Trägerelementes 1 den Abmessungen 12 des Trägersubstrates 2 im Wesentlichen entspricht, wird zur Wiederaufbereitung des Trägerelementes 1 erneut eine Saatschicht 3 auf dem zuvor verwendeten Trägersubstrat 2 ausgebildet, so dass dieses zu einem Trägerelement 1 mit seinen ursprünglichen lateralen Abmessung 11, wie in Figur 1a) dargestellt, wiederaufbereitet wird. Dieses wiederaufbereitete Trägerelement 1 wird nun weiter für die Herstellung von Waferschichten 5 genutzt, ohne hierbei ein neues Trägersubstrat 2 verwenden zu müssen. Durch die Wiederaufbereitung des Trägerelementes 1 kann somit ein Trägersubstrat 2 zumindest 50 Mal für die Herstellung von Waferschichten 5, wie in den Figuren 1b) bis 1d) dargestellt, verwendet werden.

Die Schichtstärke 8 wie auch die Schichtbreite 9 der Saatschicht 3 liegt in einem Bereich von 10 µm bis 250 µm, bevorzugt im Bereich von 25 µm bis 100 µm, besonders bevorzugt im Bereich von 40 µm bis 80 µm. Eine Schichtstärke 8 wie auch Schichtbreite 9 der Saatschicht 3, wie vorstehend genannt, hat den Vorteil der Erzeugung einer qualitativ hochwertigen Saatschicht 3, welche auch in einer entsprechend für den Prozess annehmbaren Zeit herstellbar ist.

Entsprechend den vorgegebenen Parametern wie Qualität für die Herstellung der Waferschicht 5 kann das Trägersubstrat 2 wie auch die Saatschicht 3 eine Dotierung enthalten oder ohne Dotierung auskommen.

Insbesondere das Trägersubstrat 2 weist eine n-Dotierung oder eine p-Dotierung mit einer die Dotierkonzentration im Bereich kleiner 5 x 10¹⁹ cm⁻³, bevorzugt im Bereich kleiner 1 x 10¹⁸ cm⁻³, besonders bevorzugt im Bereich kleiner 1 x 10¹⁷cm⁻³, höchst bevorzugt im Bereich kleiner 5 x 10¹⁵ cm⁻³ auf, vorliegend eine p-Dotierung mittels Bor als Dotierstoff mit einer Dotierkonzentration von 1,5 x 10¹⁶ cm⁻³. Die Herstellung von dotierten Trägersubstraten 2 mittels Zonenschmelz- oder Kristallzüchtungsverfahren geht einher mit dem Eintrag von Fremdstoffen in die Kristallstruktur, insbesondere von metallischen, oxidischen, nitridischen oder carbidischen Fremdstoffen, sowie der Ausbildung von Agglomeraten, wodurch letztendlich die gesamte Qualität und Güte des Trägersubstrates 2 durch Fremdstoffe und eine ungleichmäßige Verteilung der Dotierstoffe sinkt.

Ausgangspunkt für qualitativ hochwertige Schichten sind bereits qualitativ hochwertige Trägersubstrate 2 und Saatschichten 3. Es sollen daher qualitativ hochwertige und damit meist auch hochpreisige Substrate als Trägersubstrate 2 Verwendung finden, da die Qualität des Trägersubstrates 2 entscheidenden Einfluss letztendlich auch auf die Qualität der Waferschicht 5 hat. Daher werden nur eine geringe Dotierkonzentration aufweisende Trägersubstrate 2 bevorzugt Verwendung finden. Die Trägersubstrate 2 weisen, falls diese dotiert sind, eine p-Dotierung, insbesondere mit dem Element Bor auf.

Durch die vielfach häufigere Verwendung eines Trägersubstrates 2 bis zu 150 mal oder mehr fallen die höheren Ausgangskosten für ein hochwertigeres Trägersubstrat 2 bei der Herstellung der Vielzahl von Waferschichten 5 nicht ins Gewicht, so dass eine weitere Reduzierung der Kosten für die Herstellung einer Waferschicht 5 bei verbesserter Qualität erreicht wird.

Es ist jedoch insbesondere in Verfahrensschritt B für die Ausbildung der Trennschicht 4 vorteilhaft, wenn das Trägerelement 1 eine Dotierung aufweist. Dies wird vorliegend ermöglicht durch die Dotierung, insbesondere durch eine p-Dotierung, der Saatschicht 3, auf welcher die Trennschicht 4 durch Porosifizierung ausgebildet wird. Die Saatschicht weist hierbei eine Dotierkonzentration im Bereich von 1 x 10¹⁶ cm⁻³ bis 5 x 10¹⁹ cm⁻³, bevorzugt im Bereich von 1 x 10¹⁷ cm⁻³ bis 3 x 10¹⁹ cm⁻³, insbesondere im Bereich von 1 x 10¹⁸ cm⁻³ bis 1 x 10¹⁹ cm⁻³ auf, vorliegenden eine p-Dotierung mit dem Dotierelement Bor als Dotierstoff von 5 x 10¹⁸ cm⁻³.

Durch die epitaktische Ausbildung der Saatschicht 3 erfolgt zudem die Dotierung der Saatschicht mit dem Dotierelement gleichmäßiger und mit einem deutlich, bis zu einem Faktor 100, verringerten Eintrag von Fremdstoffen, da bei der Epitaxie die Dotierelemente oder Dotierstoffe in einer besonders hohen Reinheit vorliegen. Zudem ist auch der Eintrag von Sauerstoff, welcher mitverantwortlich für induzierte Stapelfehler in der Waferschicht 5 ist, in die Kristallstruktur durch die Epitaxie um bis zu einem Faktor 20 verringert. Durch die gleichmäße Dotierung erfolgt auch die Ausbildung der Trennschicht 4 auf der Saatschicht 3 gleichmäßiger, was sich wiederum positiv auf die Qualität der darauf hergestellten Waferschicht 5 auswirkt.

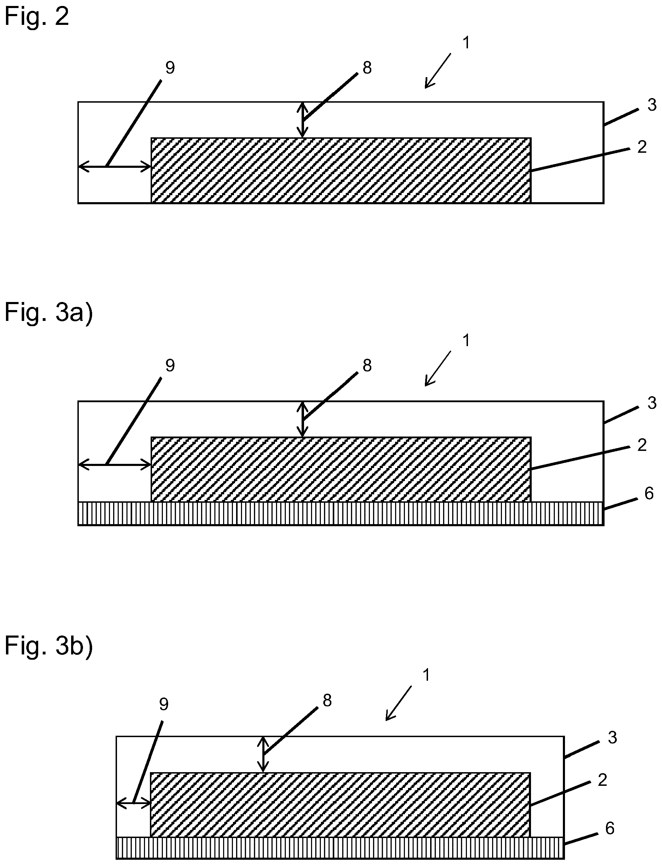

In Figur 2 ist eine besondere Ausführungsform des Trägerelementes 1 dargestellt. Das Trägerelement 1 weist wiederum ein Trägersubstrat 2 und eine Saatschicht 3 auf, wobei die Saatschicht 3 auf dem Trägersubstrat 2 mit einer größeren Schichtbreite 9 im Vergleich zur Schichtstärke 8 aufgebracht wurde.

Nach jedem Herstellungsprozess einer Waferschicht 5 in den Verfahrensschritten B bis D wird die laterale Abmessung 11 des Trägerelementes 1 wie auch die Schichtstärke 8 der Saatschicht verringert. Die lateralen Abmessungen 11' des Trägerelementes 1 verringern sich insbesondere durch das Besäumen der der Waferschicht 5 bzw. des Trägerelementes 1 zur Sicherstellung des vollständigen Entfernens der Waferschicht 5 vor dem Herstellen einer weiteren Waferschicht 5. Auch die Schichtstärke 8 der Saatschicht 3 nimmt mit jedem Ätzvorgang in Verfahrensschritt B ab.

Durch das Besäumen nimmt die laterale Abmessung 11 des Trägerelementes 1 mit jeder Waferschicht 5 stärker ab als die Schichtstärke 8 der Saatschicht 3 durch das Porosifizieren. Insbesondere unterliegt das Besäumen der Seitenflächen des Trägerelementes einer größeren Schwankung und hängt auch von der entsprechend Besäumeinrichtung ab. Zur Reduzierung der Herstellkosten für eine Waferschicht 5 werden insbesondere auch Besäumeinrichtungen eingesetzt, welche eine größere Toleranz in Bezug auf die Abtragung an den Seitenflächen des Trägerelementes 1 aufweisen, welche im Bereich von 2 µm bis 20 µm, vorliegend bei etwa 5µm, liegen. Um eine maximal mögliche Anzahl an Zyklen zur Herstellung einer Waferschicht 5 mit einem einzigen Trägerelement 1 vor dessen Aufbereitung zu ermöglichen, ist daher eine verstärkte Ausbildung der Schichtbreite 9 der Saatschicht 3 gegenüber der Schichtstärke 8 der Saatschicht 3 vorteilhaft.

In den Figuren 3a) und 3b) ist jeweils ein Trägerelement 1 dargestellt, welches an der, der Saatschicht 3 abgewandten Oberfläche des Trägersubstrates 1 eine Kontaktschicht 6 aufweist.

Die Kontaktschicht 6 ist bereits vor dem Aufbringen der Saatschicht 3 mittels Gasphasenabscheidung oder Diffusion auf das Trägersubstrat 2 aufgebracht oder mit diesem verbunden. Aber auch ein Aufbringen der Kontaktschicht 6 während oder nach dem Aufbringen der Saatschicht 3 liegt im Rahmen der Erfindung. Das Aufbringen der Kontaktschicht 6 erfolgt vor dem Verfahrensschritt B, da eine gute Kontaktierung des Trägerelementes 1 für den Prozess der Porosifizierung in Verfahrensschritt B von Bedeutung ist.

Die Kontaktschicht 6 ist aus einem polykristallinen Halbleitermaterial, insbesondere aus poly-Silizium gebildet, welches eine gute trockene Kontaktierbarkeit während der Porosifizierung des Trägerelementes 1 ermöglicht. Für eine gute Kontaktierbarkeit, insbesondere eine gute trockene Kontaktierbarkeit der Kontaktschicht 6 weist diese elektrische Eigenschaften auf, welche zumindest den elektrischen Eigenschaften eines Metalls ähneln.

Die laterale Abmessung der Kontaktschicht 6 entspricht annähernd der lateralen Abmessung 12 des Trägersubstrates 2 oder geht sogar über die laterale Abmessung 12 des Trägersubstrates 2 hinaus. Insbesondere kann die laterale Abmessung der Kontaktschicht 6 auch kleiner als die laterale Abmessung 11 des Trägerelementes 1 sein. Die Dicke der Kontaktschicht 6 liegt in einem Bereich von 0,1 bis 20µm, vorliegend bei etwa 10 µm, und somit deutlich unter der Dicke des Trägersubstrates 2 und ist auch geringer als die Schichtstärke 8.

Wie in Figur 3a) dargestellt, weist die Kontaktschicht 6 eine größere laterale Abmessung als das Trägersubstrat 2 auf, welche zur lateralen Abmessung 11 des Trägerelementes 1 identisch ist. Hierdurch ergibt sich auch eine deutlich größere Schichtbreite 9 gegenüber der Schichtstärke 8. Während eines Zyklus der Verfahrensschritte B bis D ist die laterale Verkleinerung durch die Besäumung des Trägerelementes 1 und dem anschließenden Ablösen der Waferschicht 5 größer als die Verringerung der Schichtstärke 8. Daher ist es vorteilhaft, das Trägerelement 1 mit einer größeren Schichtbreite 9 gegenüber der Schichtstärke 8 auf dem Trägersubstrat 1 aufzubringen.

Durch die vollflächige Ausbildung der Kontaktschicht 6 wird stets eine gute, insbesondere trockene Kontaktierung sichergestellt, unabhängig von der Verringerung der lateralen Abmessungen 11 des Trägerelementes 1 nach dem Ablösen einer Waferschicht 5.

### Bezugszeichenliste

- 1: Trägerelement
- 2: Trägersubstrat
- 3: Saatschicht
- 4: Trennschicht
- 5: Waferschicht
- 6: Kontaktschicht
- 7: Teil
- 8: Schichtstärke
- 9: Schichtbreite
- 10: Zwischenerzeugnis
- 11, 11': Abmessung Trägerelement
- 12: Abmessung Trägersubstrat

## Patentansprüche

1. Verfahren zur Herstellung einer Waferschicht (5), umfassend die Verfahrensschritte:
A Bereitstellen eines Trägerelementes (1);
B Porosifizieren des Trägerelementes (1) an zumindest einer Oberfläche zur Erzeugung einer Trennschicht (4);
C Aufbringen einer Waferschicht (5) auf die Trennschicht (4) des Trägerelementes (1) mittels Epitaxie; und
D Ablösen der Waferschicht (5) von dem Trägerelement (1),
wobei die Verfahrensschritte B bis D zumindest einmal, bevorzugt mehrfach mit dem Trägerelement (1) wiederholt werden,
wobeider Verfahrensschritt A die weiteren Verfahrensschritte
A1 Bereitstellen eines Trägersubstrates (2); und
A2 Aufbringen einer Saatschicht (3) auf zumindest eine Oberfläche und zumindest eine Seitenfläche des Trägersubstrates (2) mittels Epitaxie zur Herstellung des Trägerelementes (1);
umfasst, **dadurch gekennzeichnet, dass** die Saatschicht (3) mit einer größeren Schichtbreite (9) als Schichtstärke (8) aufgebracht wird.

2. Verfahren nach Anspruch 1, **dadurch gekennzeichnet, dass** die Saatschicht (3) die eine Oberfläche und alle Seitenflächen des Trägersubstrates (2) ummantelnd aufgebracht wird.

3. Verfahren nach einem der vorhergehenden Ansprüche, **dadurch**
**gekennzeichnet, dass** das Trägersubstrat (2) und die Saatschicht (3) aus Silizium, Germanium oder Galliumarsenid ausgebildet sind oder werden.

4. Verfahren nach einem der vorhergehenden Ansprüche, **dadurch**
**gekennzeichnet, dass** das Trägersubstrat (2) n-dotiert oder p-dotiert ist, wobei die Dotierkonzentration im Bereich kleiner 5 x 10¹⁹ cm⁻³, bevorzugt im Bereich kleiner 1 x 10¹⁸ cm⁻³, besonders bevorzugt im Bereich kleiner 1 x 10¹⁷ cm⁻³, höchst bevorzugt im Bereich kleiner 5 x 10¹⁵ cm⁻³ liegt.

5. Verfahren nach einem der vorhergehenden Ansprüche, **dadurch**
**gekennzeichnet, dass** die Saatschicht (3) auf der zumindest einen Oberfläche des Trägersubstrates (2) mit einer Schichtstärke (8) im Bereich von 10 µm bis 250 µm, bevorzugt im Bereich von 25 µm bis 100 µm, besonders bevorzugt im Bereich von 40 µm bis 80 µm aufgebracht wird und/oder dass die Saatschicht (3) auf der zumindest einen Seitenfläche des Trägersubstrates (2) mit einer Schichtbreite (9) im Bereich von 10 µm bis 600 µm, bevorzugt im Bereich von 25 µm bis 400 µm, besonders bevorzugt im Bereich von 50 µm bis 250 µm aufgebracht wird.

6. Verfahren nach einem der vorhergehenden Ansprüche, **dadurch**
**gekennzeichnet, dass** die Saatschicht (3) während des Aufbringens dotiert, insbesondere p-dotiert wird mit einer Dotierkonzentration im Bereich von 1 x 10¹⁶ cm⁻³ bis 5 x 10¹⁹ cm⁻³, bevorzugt im Bereich von 1 x 10¹⁷ cm⁻³ bis 3 x 10¹⁹ cm⁻³, insbesondere im Bereich von 1 x 10¹⁸ cm⁻³ bis 1 x 10¹⁹ cm⁻³.

7. Verfahren nach einem der vorhergehenden Ansprüche, **dadurch**
**gekennzeichnet, dass** auf der der Saatschicht (3) abgewandten Oberfläche des Trägersubstrates (2) eine Kontaktschicht (6) vor, während oder nach dem Aufbringen der Saatschicht (3) aufgebracht, ausgebildet oder angeordnet wird.

8. Verfahren nach Anspruch 7, **dadurch gekennzeichnet, dass** die
Kontaktschicht (6) aus polykristallinem Halbleitermaterial, insbesondere aus poly-Silizium, gebildet ist oder wird und/oder dass die Kontaktschicht (6) über das Trägersubstrat (2) überstehend ausgebildet oder angeordnet wird.

9. Verfahren nach einem der Ansprüche 7 oder 8, **dadurch gekennzeichnet, dass** die Kontaktschicht (6) eine Dicke im Bereich von 0,1 bis 20 µm, insbesondere im Bereich von 1 bis 12 µm aufweist.

10. Verfahren nach einem der Ansprüche 7 bis 9, **dadurch gekennzeichnet, dass** die Kontaktschicht (6) durch Diffusion von einer Diffusionsschicht auf der der Saatschicht (3) abgewandten Oberfläche des Trägersubstrates (2) in das Trägersubstrat (2) ausgebildet wird, wobei die Diffusionsschicht insbesondere durch ein Halteelement zum Halten des Trägersubstrates (2) während des Verfahrensschrittes A2 ausgebildet wird oder vor dem Verfahrensschritt A2 auf der der Saatschicht (3) abgewandten Oberfläche des Trägersubstrates (2) aufgebracht wird.

11. Verfahren nach einem der vorhergehenden Ansprüche, **dadurch**
**gekennzeichnet, dass** die Saatschicht (3) mit einer inhomogenen Schichtstärke (8) auf das Trägersubstrat (2) aufgebracht wird, wobei insbesondere die Schichtstärke (8) zumindest zu einer, bevorzugt zu zwei gegenüberliegenden Seitenflächen des Trägersubstrates (2) hin zunimmt oder abnimmt.

12. Trägerelement (1) für die Herstellung einer Waferschicht (5), umfassend ein Trägersubstrat (2), insbesondere aus Silizium, Germanium oder Galliumarsenid,
eine epitaktische Saatschicht (3), welche auf zumindest eine Oberfläche und zumindest eine Seitenfläche des Trägersubstrats (2) aufgebracht ist, bevorzugt die eine Oberfläche und alle Seitenflächen des Trägersubstrates (2) ummantelt; und
eine Trennschicht (4), gebildet durch das Porosifizieren der zumindest einen Oberfläche der epitaktischen Saatschicht (3), **dadurch gekennzeichnet, dass** die Saatschicht (3) eine größere Schichtbreite (9) als Schichtstärke (8) aufweist.

13. Trägerelement (1) nach Anspruch 12, **dadurch gekennzeichnet, dass** die Saatschicht (3) auf der zumindest einen Oberfläche des Trägersubstrates (2) eine Schichtstärke (8) im Bereich von 10 µm bis 250 µm, bevorzugt im Bereich von 25 µm bis 100 µm, besonders bevorzugt im Bereich von 40 µm bis 80 µm aufweist und/oder dass die Saatschicht (3) auf der zumindest einen Seitenfläche des Trägersubstrates (2) eine Schichtbreite (9) im Bereich von 10 µm bis 600 µm, bevorzugt im Bereich von 25 µm bis 400 µm, besonders bevorzugt im Bereich von 50 µm bis 250 µm aufweist.

14. Trägerelement (1) nach einem der Ansprüche 12 oder 13, **dadurch**
**gekennzeichnet, dass** auf der der Saatschicht (3) abgewandten Oberfläche des Trägersubstrates (2) eine Kontaktschicht (6), bevorzugt aus polykristallinem Halbleitermaterial, insbesondere poly-Silizium, angeordnet ist.

15. Zwischenerzeugnis (10) umfassend ein Trägerelement (1) nach einem der Ansprüche 12 bis 14 und eine auf der Trennschicht (4) angeordnete epitaktische Waferschicht (5), insbesondere aus Silizium.

## Claims

1. Method of producing a wafer layer (5), comprising the method steps of:
A providing a carrier element (1);
B porosifying the carrier element (1) on at least one surface for generating a separation layer (4);
C epitaxially applying a wafer layer (5) to the separation layer (4) of the carrier element (1); and
D detaching the wafer layer (5) from the carrier element (1),
wherein the method steps B to D are repeated at least once, preferably multiple times, with the carrier element (1);
wherein the method step A comprises the further method steps of
A1 providing a carrier substrate (2); and
A2 epitaxially applying a seed layer (3) to at least one surface and at least one lateral face of the carrier substrate (2) for the production of the carrier element (1);
**characterised in that** the seed layer (3) is applied with a larger layer width (9) than layer thickness (8).

2. Method according to claim 1, **characterised in that** the seed layer (3) is applied which covers the one surface and all lateral faces of the carrier substrate (2).

3. Method according to any one of the preceding claims, **characterised in that** the carrier substrate (2) and the seed layer (3) are formed or have been formed from silicon, germanium or gallium arsenide.

4. Method according to any one of the preceding claims, **characterised in that** the carrier substrate (2) is n-doped or p-doped, wherein the dopant concentration is in a range of less than 5 × 10¹⁹ cm⁻³, preferably in a range of less than 1 × 10¹⁸ cm⁻³, most preferably in a range of less than 1 × 10¹⁷ cm⁻³, still most preferably in a range of less than 5 × 10¹⁵ cm⁻³.

5. Method according to any one of the preceding claims, **characterised in that** the seed layer (3) is applied on the at least one surface of the carrier substrate (2) with a layer thickness (8) in a range of 10 µm to 250 µm, preferably in a range of 25 µm to 100 µm, most preferably in a range of 40 µm to 80 µm, and/or that the seed layer (3) is applied on the at least one lateral face of the carrier substrate (2) with a layer width (9) in a range of 10 µm to 600 µm, preferably in a range of 25 µm to 400 µm, most preferably in a range of 50 µm to 250 µm.

6. Method according to any one of the preceding claims, **characterised in that** the seed layer (3) is doped, in particular p-doped during the application with a dopant concentration in a range of 1 × 10¹⁶ cm⁻³ to 5 × 10¹⁹ cm⁻³, preferably in a range of 1 × 10¹⁷ cm⁻³ to 3 × 10¹⁹ cm⁻³, in particular in a range of 1 × 10¹⁸ cm⁻³ to 1 × 10¹⁹ cm⁻³

7. Method according to any one of the preceding claims, **characterised in that** a contact layer (6) is applied, formed or arranged on the surface of the carrier substrate (2) facing away from the seed layer (3) before, during or after the application of the seed layer (3).

8. Method according to claim 7, **characterised in that** the contact layer (6) is formed or has been formed from polycrystalline semiconductor material, in particular from polysilicium, and/or **in that** the contact layer (6) is formed or arranged to project beyond the carrier substrate (2).

9. Method according to any one of claims 7 or 8, **characterised in that** the contact layer (6) has a thickness in a range of 0.1 to 20 µm, in particular in a range of 1 to 12 µm.

10. Method according to any one of claims 7 to 9, **characterised in that** the contact layer (6) is formed by diffusion of a diffusion layer on the surface of the carrier substrate (2) facing away from the seed layer (3) into the carrier substrate (2), wherein the diffusion layer in particular is formed by a retaining element for retaining the substrate layer (2) during the method step A2, or is applied on the surface of the carrier substrate (2) facing away from the seed layer (3) before the method step A2.

11. Method according to any one of the preceding claims, **characterised in that** the seed layer (3) is applied to the carrier substrate (2) with an inhomogeneous layer thickness (8), wherein in particular the layer thickness (8) increases or decreases at least towards one, preferably two opposite lateral faces of the carrier substrate (2).

12. Carrier element (1) for the production of a wafer layer (5), comprising a carrier substrate (2), in particular from silicon, germanium or gallium arsenide;
an epitaxial seed layer (3), which is applied to at least one surface and at least one lateral face of the carrier substrate (2), which preferably covers one surface and all lateral faces of the carrier substrate (2); and
a separation layer (4), formed by porosifying the at least one surface of the epitaxial seed layer (3), **characterised in that** the seed layer (3) has a larger layer width (9) than layer thickness (8).

13. Carrier element (1) according to claim 12, **characterised in that** the seed layer (3) on the at least one surface of the carrier substrate (2) has a layer thickness (8) in a range of 10 µm to 250 µm, preferably in a range of 25 µm to 100 µm, most preferably in a range of 40 µm to 80 µm, and/or **in that** the seed layer (3) is applied on the at least one lateral face of the carrier substrate (2) with a layer width (9) in a range of 10 µm to 600 µm, preferably in a range of 25 µm to 400 µm, most preferably in a range of 50 µm to 250 µm.

14. Carrier element (1) according to any one of claims 12 or 13, **characterised in that** a contact layer (6), preferably made of polycrystalline semiconductor material, in particular polysilicium, is arranged on the surface of the carrier substrate (2) facing away from the seed layer (3).

15. Intermediate product (10), comprising a carrier element (1) according to any one of claims 12 to 14 and an epitaxial wafer layer (5), arranged on the separation layer (4), in particular from silicium.

## Revendications

1. Procédé de fabrication d'une couche de tranche (5) comprenant les étapes de procédé suivantes :
A la fourniture d'un élément de support (1) ;
B la porosification de l'élément de support (1) au niveau d'au moins une surface pour la génération d'une couche de séparation (4) ;
C l'application d'une couche de tranche (5) sur la couche de séparation (4) de l'élément de support (1) par épitaxie ; et
D le détachement de la couche de tranche (5) de l'élément de support (1),
dans lequel les étapes de procédé B à D sont répétées au moins une fois, de préférence plusieurs fois avec l'élément de support (1),
dans lequel l'étape de procédé A comprend les autres étapes de procédé suivantes
A1 la fourniture d'un substrat de support (2) ; et
A2 l'application d'une couche de semence (3) sur au moins une surface et au moins une surface latérale du substrat de support (2) par épitaxie pour la fabrication de l'élément de support (1) ;
**caractérisé en ce que** la couche de semence (3) est appliquée avec une largeur de couche (9) supérieure à l'épaisseur de couche (8).

2. Procédé selon la revendication 1, **caractérisé en ce que** la couche de semence (3) est appliquée de manière à envelopper la une surface et toutes les faces latérales du substrat de support (2).

3. Procédé selon l'une quelconque des revendications précédentes, **caractérisé en ce que** le substrat de support (2) et la couche de semence (3) sont réalisés en silicium, germanium ou arséniure de gallium.

4. Procédé selon l'une quelconque des revendications précédentes, **caractérisé en ce que** le substrat de support (2) est dopé n ou dopé p, dans lequel la concentration de dopage se situe dans la plage inférieure à 5 x 10¹⁹ cm⁻³, de préférence dans la plage inférieure à 1 x 10¹⁸ cm⁻³, le plus préférentiellement dans la plage inférieure à 1 x 10¹⁷ cm⁻³, de manière préférée entre toutes dans la plage inférieure à 5 x 10¹⁵ cm⁻³.

5. Procédé selon l'une quelconque des revendications précédentes, **caractérisé en ce que** la couche de semence (3) est appliquée sur la au moins une surface du substrat de support (2) avec une épaisseur de couche (8) dans la plage de 10 µm à 250 µm, de préférence dans la plage de 25 µm à 100 µm, le plus préférentiellement dans la plage de 40 µm à 80 µm et/ou **en ce que** la couche de semence (3) est appliquée sur la au moins une face latérale du substrat de support (2) avec une largeur de couche (9) dans la plage de 10 µm à 600 µm, de préférence dans la plage de 25 µm à 400 µm, le plus préférentiellement dans la plage de 50 µm à 250 µm.

6. Procédé selon l'une quelconque des revendications précédentes, **caractérisé en ce que** la couche de semence (3) est dopée pendant l'application, en particulier est dopée p avec une concentration de dopage dans la plage de 1 x 10¹⁶ cm⁻³ à 5 x 10¹⁹ cm⁻³, de préférence dans la plage de 1 x 10¹⁷ cm⁻³ à 3 x 10¹⁹ cm⁻³, en particulier dans la plage de 1 x 10¹⁸ cm⁻³ à 1 x 10¹⁹ cm⁻³.

7. Procédé selon l'une quelconque des revendications précédentes, **caractérisé en ce qu'**une couche de contact (6) est appliquée, réalisée ou disposée sur la surface du substrat de support (2) opposée à la couche de semence (3) avant, pendant ou après l'application de la couche de semence (3).

8. Procédé selon la revendication 7, **caractérisé en ce que** la couche de contact (6) est formée d'un matériau semi-conducteur polycristallin, en particulier de polysilicium et/ou **en ce que** la couche de contact (6) est formée ou agencée de manière à faire saillie au-delà du substrat de support (2).

9. Procédé selon l'une quelconque des revendications 7 ou 8, **caractérisé en ce que** la couche de contact (6) présente une épaisseur dans la plage de 0,1 à 20 µm, en particulier dans la plage de 1 à 12 µm.

10. Procédé selon l'une quelconque des revendications 7 à 9, **caractérisé en ce que** la couche de contact (6) est formée dans le substrat de support (2) par diffusion d'une couche de diffusion sur la surface du substrat de support (2) éloignée de la couche de semence (3), dans lequel la couche de diffusion est réalisée en particulier par un élément de retenue pour la retenue du substrat de support (2) pendant l'étape de procédé A2 ou est appliquée avant l'étape de procédé A2 sur la surface du substrat de support (2) éloignée de la couche de semence (3).

11. Procédé selon l'une quelconque des revendications précédentes, **caractérisé en ce que** la couche de semence (3) est appliquée sur le substrat de support (2) avec une épaisseur de couche (8) non homogène, dans lequel en particulier l'épaisseur de couche (8) augmente ou diminue au moins vers une, de préférence vers deux surfaces latérales opposées du substrat de support (2).

12. Élément de support (1) pour la fabrication d'une couche de tranche (5) comprenant un substrat de support (2), en particulier en silicium, germanium ou arséniure de gallium,
une couche de semence (3) épitactique qui est appliquée sur au moins une surface et au moins une face latérale du substrat de support (2), entoure de préférence la une surface et toutes les faces latérales du substrat de support (2) ; et
une couche de séparation (4) formée par la porosification de la au moins une surface de la couche de semence (3) épitactique, **caractérisé en ce que** la couche de semence (3) présente une largeur de couche (9) supérieure à l'épaisseur de couche (8).

13. Élément de support (1) selon la revendication 12, **caractérisé en ce que** la couche de semence (3) présente sur la au moins une surface du substrat de support (2) une épaisseur de couche (8) dans la plage de 10 µm à 250 µm, de préférence dans la plage de 25 µm à 100 µm, le plus préférentiellement dans la plage de 40 µm à 80 µm et/ou **en ce que** la couche de semence (3) présente sur la au moins une face latérale du substrat de support (2) une largeur de couche (9) dans la plage de 10 µm à 600 µm, de préférence dans la plage de 25 µm à 400 µm, le plus préférentiellement dans la plage de 50 µm à 250 µm.

14. Élément de support (1) selon l'une quelconque des revendications 12 ou 13, **caractérisé en ce qu'**une couche de contact (6), de préférence en matériau semi-conducteur polycristallin, en particulier en polysilicium, est disposée sur la surface du substrat de support (2) éloignée de la couche de semence (3).

15. Produit intermédiaire (10) comprenant un élément de support (1) selon l'une quelconque des revendications 12 à 14 et une couche de tranche (5) épitactique, en particulier en silicium, agencée sur la couche de séparation (4).
